# EUROPEAN PATENT APPLICATION

(11) **EP 1 416 329 A1**
(43) Date of publication of application: **06.05.2004**
(21) Application number: 03256903.0
(22) Date of filing: 31.10.2003
(51) Int. Cl.: G03F 7/20

(54) **Lithographic apparatus and device manufacturing method**

(30) Priority: 31.10.2002 EP 02257568
(71) Applicant: ASML Netherlands B.V., 5503 LA Veldhoven (NL)
(72) Inventor: Kurt, Ralph, 5655 CG Eindhoven (NL)
(74) Representative: Leeming, John Gerard

(57) **Abstract**

Optical elements such as multi-layer mirrors for EUV lithography machines are provided, the optical elements having at least one layer (4) containing one or more Buckminsterfullerenes. Typically the fullerenes are present as a capping layer, which is either provided as the outer capping layer of the optical element or forms a sub-capping layer which is adjacent to an outer capping layer formed of a different material. The fullerene containing layer(s) may alternatively or additionally be present as an interlayer between two layers of a multi-layer mirror.

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus -commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

The present invention is largely directed towards apparatus employing electromagnetic radiation in the extreme ultra-violet (EUV) range. Typically, the radiation used has a wavelength below about 50nm, preferably below about 20nm and most preferably below about 15nm. An example of a wavelength in the EUV region which is gaining considerable interest in the lithography industry is 13.4nm, although there are other promising wavelengths in this region, such as 11nm, for example.

Optical elements for use in EUV apparatus, e.g. multi-layered thin film mirrors, are especially sensitive to physical and chemical damage which can significantly reduce their reflectivity and optical quality. Particular problems associated with multi-layer mirrors exposed to EUV radiation are (i) oxidation of the top layers, (ii) carbon growth on the surface of the mirror, and (iii) intermixing of the multi-layers. Similar problems arise in connection with optical elements other than multi-layer mirrors, even those not permanently exposed to EUV. This is because carbon growth can occur simply through secondary electron radiation which may affect all optical elements.

In order to address these problems, protective capping layers for optical elements have been proposed. Previously suggested materials for use as the protective capping layer include ruthenium-molybdenum protective layers and also carbon or boron carbide (B₄C) layers. However, none of these materials is fully satisfactory. Ruthenium-molybdenum multi-layers show strong signs of irreversible degradation after approximately 50 hours of irradiation under realistic tool conditions (i.e. a substantial vacuum with a residual pressure of oxidising and carbonising agents, combined with high energy, low wavelength electromagnetic radiation). The desired lifetime for an EUV multi-layer mirror is in the order of 30,000 hours and the ruthenium-molybdenum capped multi-layer mirrors therefore fall well short of this. The carbon and boron carbide capping layers are also subject to degradation, in this case thought to be due to the combination of secondary electrons and molecules present in the system (e.g. water and hydrocarbons). Further, such layers cannot withstand the cleaning steps which are currently used in the art.

It is an object of the present invention to provide optical elements which have a high resistance to physical and chemical attack and which have an improved lifetime.

This and other objects are achieved according to the invention in a lithographic apparatus as specified in the opening paragraph, characterized by at least one optical element having at least one layer comprising one or more Buckminsterfullerenes.

The use of a Buckminsterfullerene (also termed "fullerene") as a capping layer provides a very stable, chemically inert protective coating. A typical fullerene, C₆₀, has a very high binding energy (approximately 7.3eV) which is in the order of the binding energy of diamond (approximately 7.4eV). C₆₀ and other fullerenes are therefore extremely resistant to oxidation and radiation induced damage. In contrast, graphitic/amorphous carbon has a binding energy of about 3-5eV and has therefore less resistance to chemical attack. A fullerene capping layer is able to retain its initial structure for long periods of irradiation, providing improved optical processing. The longer lifetime of the mirror also reduces the down-time of the apparatus.

A further advantage of the fullerene capping layer is a reduction in carbon growth on top of the mirror. The major cause of carbon growth on mirrors has been found to be the dissociation of hydrocarbons adsorbed to the mirror surface. This dissociation is primarily due to the release of secondary electrons from the mirror surface during radiation. Fullerenes are, however, very efficient electron acceptors. A fullerene capping layer will thus reduce the secondary electron yield at the mirror surface, resulting in a reduction in hydrocarbon dissociation and consequently less carbon growth. Moreover, fullerene layers are characterized by a low sticking probability.

The present invention involves three specific embodiments. In the first, the fullerene layer forms the outer capping layer of the optical element. Since fullerenes are chemically inert, this outer capping layer is characterized by a low sticking probability. This will in turn reduce carbon contamination and thereby reduce the required frequency of cleaning processes.

The second proposal involves the fullerene film forming a sub-capping layer with an outer capping layer, for example a ruthenium layer, present on top of the fullerene layer. An advantage of this arrangement is that inter-mixing of the multi-layer with the capping layer is reduced. Fullerenes have a relatively low density and therefore a fairly thick capping layer can be used without increasing the optical absorption. This leads to an increased distance between the outer capping layer and the multi-layer mirror resulting in an improved diffusion barrier.

In a further embodiment, fullerene-containing inter-layer(s) are present at the interfaces of individual layers of a multi-layer mirror. This leads to a reduction in stress and intermixing of the layers.

According to a further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,
characterized by providing at least one optical element having at least one layer comprising one or more Buckminsterfullerenes.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 depicts the layer structure of a capped multi-layer mirror according to an embodiment of the invention;
Figure 3 depicts the layer structure of a capped multi-layer mirror according to a second embodiment of the invention; and
Figure 4 depicts the layer structure of a capped multi-layer mirror according to a third embodiment of the invention.

In the Figures, corresponding reference symbols indicate corresponding parts.

### Embodiment 1

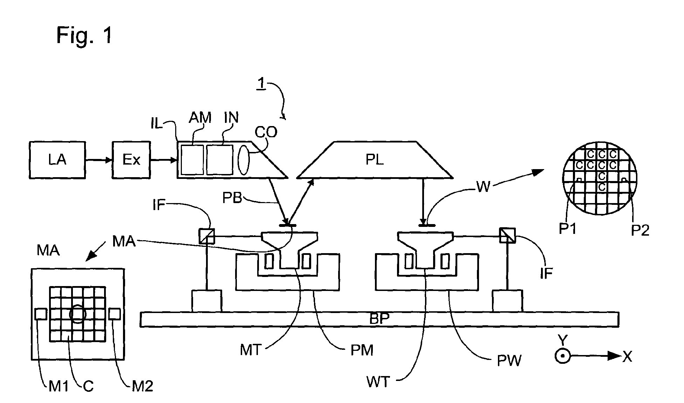

Figure 1 schematically depicts a lithographic projection apparatus according to a particular embodiment of the invention. The apparatus comprises:
a radiation system Ex, IL, for supplying a projection beam PB of radiation (e.g. EUV radiation), which in this particular case also comprises a radiation source LA;
a first object table (mask table) MT provided with a mask holder for holding a mask MA (*e.g.* a reticle), and connected to first positioning means for accurately positioning the mask with respect to item PL;
a second object table (substrate table) WT provided with a substrate holder for holding a substrate W (*e.g.* a resist-coated silicon wafer), and connected to second positioning means for accurately positioning the substrate with respect to item PL;
a projection system ("lens") PL (*e.g.* a refractive/catadioptric lens system/mirror group) for imaging an irradiated portion of the mask MA onto a target portion C (*e.g.* comprising one or more dies) of the substrate W.
As here depicted, the apparatus is of a reflective type (*e.g.* has a reflective mask). However, in general, it may also be of a transmissive type, for example (*e.g.* with a transmissive mask). Alternatively, the apparatus may employ another kind of patterning means, such as a programmable mirror array of a type as referred to above.

The source LA (*e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (*e.g.* with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, e.g. after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go *(i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a *speed V* = *Mv,* in which *M* is the magnification of the lens PL (typically, *M* = 1/4 or 1/5). In this manner, a relatively large target portion C can be exposed, without having to compromise on resolution.

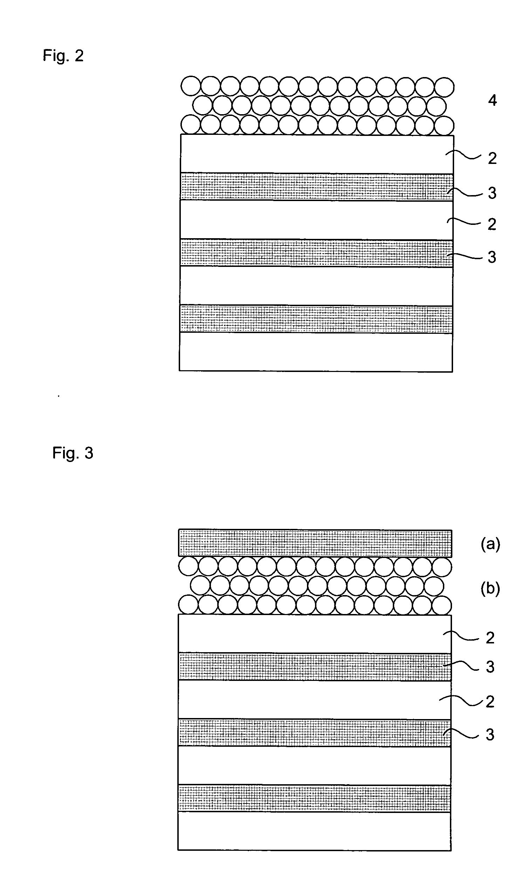

Figures 2 to 4 depict the proposed application of a fullerene capping layer. In each figure, the optical element is a multi-layer mirror made up of alternating layers of silicon (2) and molybdenum (3). Figure 2 illustrates a first embodiment of the invention in which the outer capping layer (4) comprises a fullerene. Typically, and as here depicted, the fullerene-containing layer is placed directly onto the multi-layer mirror and thus only a single capping layer is present. However, in alternative embodiments, additional capping layers may be present between the multi-layer mirror and the fullerene-containing layer. For example, ruthenium, irridium or graphitic carbon layers may be used, and/or further fullerene-containing layers.

Figure 3 depicts an alternative embodiment of the invention in which a sub-capping layer comprises the one or more fullerenes. As depicted in Figure 3, two capping layers are present, an outer capping layer (a) and a sub-capping layer (b), the sub-capping layer (b) comprising fullerene(s). The outer capping layer may, for example, be formed of ruthenium but alternative capping materials such as irridium or graphitic carbon may equally be used.

Typically, and as depicted in Figure 3, two capping layers are present. However, it is possible to include one or more further capping layers either between the sub-capping layer (b) and the multi-layer mirror or between the outer capping layer (a) and the sub-capping layer (b). These additional capping layers may be formed of any suitable material including ruthenium, graphitic carbon or further layers of fullerenes. Typically, however, a fullerene layer is present adjacent to the outer capping layer.

Figures 2 and 3 depict multi-layer mirrors formed of molybdenum and silicon in which the capping layer or layers are placed onto a silicon layer. However, the capping layer or layers may equally be placed onto a molybdenum layer. Alternatively, the capping layer or layers of the invention may be used with multi-layer structures other than molybdenum/silicon mirrors. Optical elements other than multi-layer mirrors may also be used. For example, the capping layers of the invention may be employed with grazing incidence mirrors, collectors, reticles and all types of sensors.

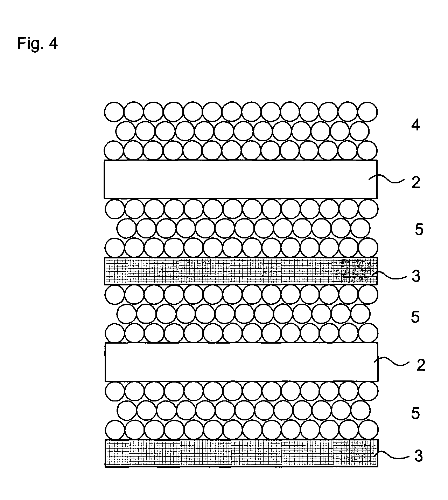

Figure 4 depicts an alternative embodiment of the invention which is applicable only to multi-layer mirrors. In this embodiment, a fullerene-containing inter-layer is present at one or more of the interfaces between individual layers of the multi-layer mirror. The silicon (2) and molybdenum (3) layers may be replaced with other suitable materials if desired. In this embodiment a capping layer is typically present, for example the capping layers depicted in Figures 2 and 3 may be used.

A wide range of different fullerenes can be used in the present invention. For example, C₆₀, C₇₀, C₇₄, C₈₀, C₈₂ and other larger fullerenes including C₂₆₀ and C₉₆₀. The term Buckminsterfullerene is intended to encompass structures containing only carbon such as those listed above, as well as (i) structures in which one or more carbon atoms is replaced with a heteroatom, for example N (for example C₅₉N); (ii) filled fullerenes in which an atom or molecule is present inside the fullerene ring (for example La-C₆₀ and Li-C₆₀); and (iii) multi-shelled nestled fullerenes. Preferred fullerenes are structures containing carbon only in particular C₆₀, C₇₀, C₇₄, C₈₀ and C₈₂. C₆₀ is most preferred.

The fullerene layer may be added to the surface of an optical element using standard techniques. Typically, the fullerene is evaporated (thermally or using electron evaporation) from a material containing the desired fullerene. Then, one or more layers of molecules are allowed to grow onto the optical element. This typically leads to a layer having an fcc lattice structure in which molecules are relatively weakly bound to one another. A more densely packed, tightly bound layer can be formed by polymerising the fullerenes to form chains or networks of molecules connected by covalent bonds. This can be done for example by photo-excitation, using increased pressure or by alkali-doping.

Typically, a capping layer comprising fullerenes will contain from 1 to 5 layers of molecules. Preferably, from 2 to 3 layers of molecules will be present. The thickness of the fullerene-containing capping layer is typically less than 3nm but thicknesses of approximately 7 to 8nm may also usefully be employed. Other capping layers, such as the outer capping layer (a) of Figure 3, are preferably in the order of 1 to 3nm in thickness.

Whilst specific embodiments of the invention have been described above, it will be appreciated that the invention may be practiced otherwise than as described. The description is not intended to limit the invention.

## Claims

1. A lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate,
**characterized by** at least one optical element having at least one layer comprising one or more Buckminsterfullerenes.

2. An apparatus according to claim 1, wherein the optical element has one or more capping layers on its surface, at least one of said capping layers comprising one or more Buckminsterfullerenes.

3. An apparatus according to claim 2, wherein the outer layer of said one or more capping layers comprises one or more Buckminsterfullerenes.

4. An apparatus according to claim 3, wherein the optical element has a single capping layer on its surface.

5. An apparatus according to claim 2, wherein the optical element has at least two capping layers including an outer capping layer and a sub-capping layer between the outer capping layer and the optical element, said sub-capping layer comprising one or more Buckminsterfullerenes.

6. An apparatus according to claim 5, wherein the sub-capping layer is adjacent to the outer capping layer.

7. An apparatus according to any one of the preceding claims, wherein the optical element is a multi-layer mirror.

8. An apparatus according to claim 7, wherein a layer comprising one or more Buckminsterfullerenes is present at one or more of the interfaces between any two layers of the multi-layer mirror.

9. An apparatus according to any one of the preceding claims, wherein the capping layer comprising one or more Buckminsterfullerenes is from 1 to 3 nm or from 7 to 8 nm in thickness.

10. An apparatus according to any one of the preceding claims, wherein the capping layer comprising one or more Buckminsterfullerenes has from 1 to 5, preferably from 2 to 3, layers of Buckminsterfullerene molecules.

11. An apparatus according to any one of the preceding claims, wherein said one or more Buckminsterfullerenes comprises C₆₀.

12. A device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,
**characterized by** providing at least one optical element having at least one layer comprising one or more Buckminsterfullerenes.
